# EUROPEAN PATENT APPLICATION

(11) **EP 4 068 397 A1**
(43) Date of publication of application: **05.10.2022**
(21) Application number: 22164554.2
(22) Date of filing: 25.03.2022
(51) Int. Cl.: H01L 33/00, H01L 33/44

(54) **A METHOD TO REMOVE AN ISOLATION LAYER ON THE CORNER BETWEEN THE SEMICONDUCTOR LIGHT EMITTING DEVICE TO THE GROWTH SUBSTRATE**

(30) Priority: 31.03.2021 US 202163168341 P; 16.02.2022 US 202217673234
(71) Applicant: Semileds Corporation, Chu-Nan, Miao-Li County 350 (TW); Shin-Etsu Chemical Co., Ltd., Tokyo 100-0005 (JP)
(72) Inventor: Chu, Chen-Fu, Chu-Nan, Miao-Li County (TW); Chan, Shih-Kai, Chu-Nan, Miao-Li County (TW); Doan, Trung Tri, Chu-Nan, Miao-Li County (TW); Doan, David Trung, Chu-Nan, Miao-Li County (TW); Ogawa, Yoshinori, Tokyo (JP); Kondo, Kazunori, Tokyo (JP); Ozai, Toshiyuki, Tokyo (JP); Matsumoto, Nobuaki, Tokyo (JP); Kitagawa, Taichi, Tokyo (JP); Shih, Yi-Feng, Chu-Nan, Miao-Li County (TW)
(74) Representative: Lang, Christian

(57) **Abstract**

A method for fabricating semiconductor light emitting devices (LEDs) includes forming a plurality of light emitting diode (LED) structures having sidewall P-N junctions on a growth substrate, and forming an isolation layer on the light emitting diode (LED) structures having corners at intersections of the epitaxial structures with the growth substrate. The method also includes forming an etchable covering channel layer on the isolation layer, forming a patterning protection layer on the covering channel layer, forming etching channels in the covering channel layer using a first etching process, and removing the corners of the isolation layer by etching the isolation layer using a second etching process. Following the second etching process the isolation layer covers the sidewall P-N junctions. The method can also include bonding the growth substrate to a carrier and separating the growth substrate from the light emitting diode (LED) structures using a laser lift off (LLO) process.

## Description

### Cross Reference to Related Application

This application claims priority from US Provisional No. 63/168,341, filed 03/31/2021, which is incorporated herein by reference.

### Background

This disclosure relates to the fabrication of semiconductor light emitting devices (LEDs) and particularly to methods for fabricating semiconductor light emitting devices (LEDs) in which a corner isolation layer on a growth substrate is formed and removed.

In the fabrication of semiconductor light emitting devices (LEDs), epitaxial structures can be formed using a growth substrate, such as a wafer comprised of a sapphire substrate. An exemplary (LED) epitaxial structure can include an undoped GaN layer, an n-type GaN layer, a single or multiple quantum well layer and a p-type GaN layer formed on the wafer. Light emitting device (LED) chips can be formed on the wafer by selectively removing layers of the (LED) epitaxial structure and exposing the sapphire substrate. For example, the sapphire substrate can be exposed in street regions of the wafer in a selected pattern to isolate each light emitting device (LED). For semiconductor light emitting device (LED) chips having a polygonal outline, each (LED) chip can be spatially separated from adjacent (LED) chips by street regions having a criss-cross pattern.

The present disclosure is directed to fabrication methods for semiconductor light emitting devices (LEDs) in which an isolation layer is formed on an epitaxial structure and selectively removed in a corner of the epitaxial structure proximate to a growth substrate. The present disclosure also enables novel semiconductor light emitting devices (LEDs) fabricated using the method.

### Summary

A method for fabricating semiconductor light emitting devices (LEDs) includes the step of forming a plurality of light emitting diode (LED) structures on a growth substrate. The light emitting diode (LED) structures include epitaxial structures with sidewalls having sidewall P-N junctions. In illustrative embodiments, the light emitting diode (LED) structures include dual pad light emitting diode (LED) structures and vertical light emitting diode (VLED) structures in chip form. In addition, the epitaxial structures can include an undoped layer (e.g., u-GaN), an n-type layer (e.g., n-GaN), active layers (e.g., SQW or MQW) and a p-type layer (e.g., p-GaN). In some embodiments, the epitaxial structures can include mesa surround structures for recessing the sidewall P-N junctions.

The method also includes the step of forming an isolation layer on the light emitting diode (LED) structures including on the sidewall P-N junctions. The isolation layer includes corners at the intersections of the epitaxial structures with the growth substrate. In an illustrative embodiment, the growth substrate comprises a wafer containing a plurality of light emitting diode (LED) structures, and having streets that separate the individual light emitting diode (LED) structures. The isolation layer can be formed on the light emitting diode (LED) structures to a uniform thickness using a conformable deposition process, and can either cover the streets or leave the streets open.

Following forming of the isolation layer, an etchable covering channel layer can be formed on the isolation layer. The covering channel layer can comprise an etchable material such as a metal, or an oxide.

Following forming of the covering channel layer, a patterning protection layer can be formed on the covering channel layer. The patterning protection layer can comprise a patternable material such as photoresist, having openings aligned with the corners of the isolation layer.

Following forming of the patterning protection layer, etching channels can be formed in the covering channel layer using a first etching process, in which an etchant passes through the openings in the patterning protection layer to etch away portions of the covering channel layer. The etching channels are located on the corners and can be shaped and sized to surround the corners for removal by a second chemical etching step. By way of example, the covering channel layer can comprise a metal and the first etching process comprises a wet chemical etching process.

Following forming of the etching channels, the corners of the isolation layer can be removed by etching the isolation layer using a second etching process. By way of example, the isolation layer can comprise an oxide (e.g., SiO₂) and the second etching process comprises a BOE etch. During this step the isolation layer is only removed at the corners leaving the isolation layer at the sidewall P-N junction intact. In an illustrative embodiment, the etching channels are formed such that the isolation layer only isolates the sidewall of the p-type layer, the sidewall of the active layers, and a portion of the sidewall of the n-type layer.

Following etching of the isolation layer, the covering channel layer and the patterning protection layer can be removed. Depending on the materials, these layers can be removed using techniques that are known in the art.

The method can also include a step of bonding the growth substrate to a carrier having an elastic polymer material thereon. In an illustrative embodiment, the bonding step can be performed by flip chip bonding the light emitting diode (LED) structures to the carrier. The method can also include a laser lift off (LLO) step wherein the growth substrate is separated from the light emitting diode (LED) structures using a laser lift off (LLO) process.

In an alternate embodiment of the method, a covering channel layer is not formed on the isolation layer. Rather, a patterning protection layer is formed directly on the isolation layer. Then, a first etching process removes the isolation layer in the streets of the growth substrate, and a second etching process removes the corners of the isolation layer and forms undercut sidewall structures on the sidewalls of the epitaxial structures.

A semiconductor light emitting device (LED) fabricated using the method, or the alternate embodiment method, includes the isolation layer covering the sidewall P-N junction, the sidewall of the p-type layer, the sidewall of the active layers, and a portion of the sidewall of the n-type layer leaving the undoped layer exposed.

### Brief Description of the Drawings

Figure 1 is an enlarged schematic cross sectional view of a dual pad semiconductor light emitting device (LED) structure shown after forming of an isolation layer having a corner prior to a laser lift off (LLO) step of the method;
Figure 2 is an enlarged schematic cross sectional view of a plurality of dual pad semiconductor light emitting device (LED) structures shown on a growth substrate with an isolation layer not extending into the street regions thereof;
Figure 2A is an enlarged schematic cross sectional view of a plurality of dual pad semiconductor light emitting device (LED) structures shown on a growth substrate with an isolation layer extending into the street regions thereof;
Figure 3 is an enlarged schematic cross sectional view of a vertical light emitting diode (VLED) structure shown after forming of an isolation layer having a corner prior to a laser lift off (LLO) step of the method;
Figure 3A is an enlarged schematic cross sectional view of a vertical light emitting diode (VLED) structure having a mesa surround structure shown after forming of an isolation layer having a corner prior to a laser lift off (LLO) step of the method;
Figure 4 is an enlarged schematic cross sectional view of a plurality of vertical light emitting diode (VLED) structures shown on a growth substrate with an isolation layer not extending into the street regions thereof;
Figure 5 is an enlarged schematic cross sectional view illustrating a step of the method of forming an isolation layer on a plurality of vertical light emitting diode (VLED) structures on a growth substrate;
Figure 5A is an enlarged schematic cross sectional view illustrating a step of the method of forming an isolation layer on a plurality of vertical light emitting diode (VLED) structures having mesa surround structures on a growth substrate;
Figure 6 is an enlarged schematic cross sectional view illustrating a step of the method of forming a covering channel layer on the isolation layer;
Figure 7 is an enlarged schematic cross sectional view illustrating a step of the method of forming a patterning protection layer on the covering channel layer;
Figure 8 is an enlarged schematic cross sectional view illustrating a step of the method of forming an etching channel using a first chemical etching process;
Figure 9 is an enlarged schematic cross sectional view illustrating a step of the method of etching the isolation layer using a second chemical etching process;
Figure 10 is an enlarged schematic cross sectional view illustrating a step of the method of removing the covering channel layer and the patterning protection layer;
Figure 11 is an enlarged schematic cross sectional view illustrating a step of the method of bonding the growth substrate to a carrier having an elastic polymer material thereon;
Figure 12 is an enlarged schematic cross sectional view illustrating a laser lift off (LLO) step of the method wherein the growth substrate is separated from the dual pad semiconductor light emitting device (LED) structures;
Figure 13 is an enlarged schematic cross sectional view illustrating a semiconductor light emitting device (LED) fabricated using the method;
Figures 14-17 are enlarged schematic cross sectional views illustrating an alternate embodiment method for fabricating semiconductor light emitting devices (LEDs) in which a patterning protection layer can be deposited directly on an isolation layer and the isolation layer can be etched using a first etch process to remove material in the street regions and a second etch process to form undercut sidewall structures;
Figures 18-23 are enlarged schematic cross sectional views illustrating steps of the method for fabricating semiconductor light emitting devices (LEDs);
Figures 24-27 are enlarged schematic cross sectional views illustrating steps of the alternate embodiment method for fabricating semiconductor light emitting devices (LEDs);
Figures 28-30 are enlarged schematic cross sectional views illustrating a laser lift off (LLO) step of the method or the alternate embodiment method for fabricating semiconductor light emitting devices (LEDs);
Figure 31 is a plan view of a carrier having a plurality of semiconductor light emitting device (LED) structures thereon fabricated using the method or the alternate embodiment method;
Figure 31A is a cross sectional view taken along section line 31A-31A of Figure 31 illustrating a single semiconductor light emitting device (LED) structure;
Figures 32-35 are enlarged schematic cross sectional views illustrating aspects of a prior art laser lift off (LLO) process;
Figure 36 is a plan view of a carrier having a plurality of semiconductor light emitting device (LED) structures thereon fabricated using the prior art laser lift off (LLO) process; and
Figure 36A is a cross sectional view taken along section line 36A-36A of Figure 36 illustrating a single semiconductor light emitting device (LED) structure on the carrier.

### Detailed Description

It is to be understood that when an element is stated as being "on" another element, it can be directly on the other element or intervening elements can also be present. However, the term "directly" means there are no intervening elements. In addition, although the terms "first", "second" and "third" are used to describe various elements, these elements should not be limited by the term. Also, unless otherwise defined, all terms are intended to have the same meaning as commonly understood by one of ordinary skill in the art.

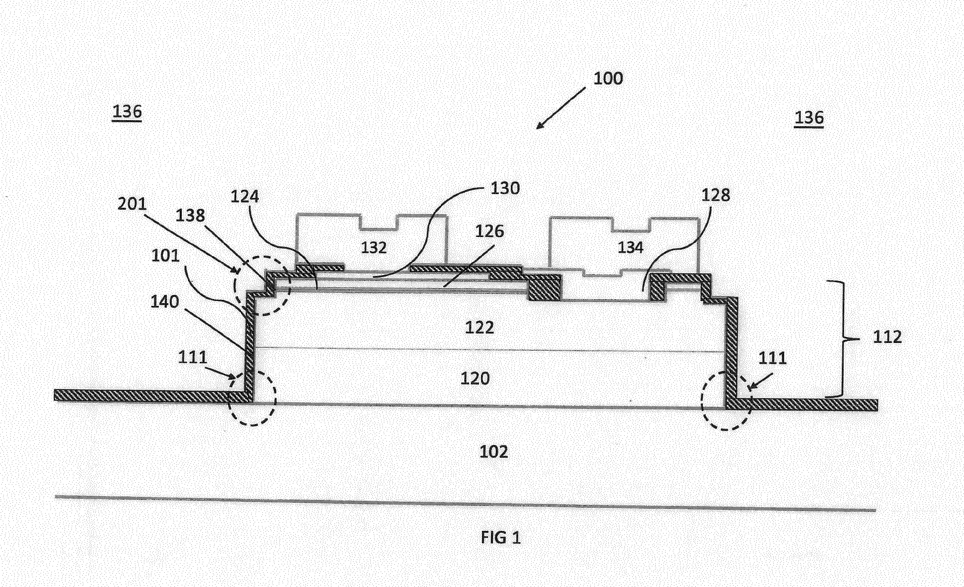

Referring to Figure 1, initial steps in the method for fabricating semiconductor light emitting devices (LEDs) are illustrated. The method includes the step of forming a plurality of light emitting diode (LED) structures 100 on a growth substrate 102 and forming an isolation layer 101 on the light emitting diode (LED) structures 100 having corners 111 proximate to the growth substrate 102. Ideally, the corners 111 have a right angle but depending on the deposition process, the angle of the corners 111 may be greater than or less than 90 degrees.

In an illustrative embodiment, the growth substrate 102 can comprise sapphire, and the light emitting diode (LED) structures 100 can comprise dual pad (LED) chips. Each light emitting diode (LED) structure 100 includes an undoped layer 120, such as u-GaN, an n-type layer 122, such as n-GaN, active layers 124, such as SQW or MQW, a p-type layer 126, such as p-GaN, an n-type conductive layer 128, such as a metal, a p-type conductive layer 130, such as a metal, a p-pad 132, such as a metal, and an n-pad 134, such as a metal.

Each light emitting diode (LED) structure 100 can be configured as a direct bandgap compound semiconductor light emitting diode (LED) structure formed using semiconductor fabrication processes. For example, the epitaxial structure 112 can be grown on the growth substrate 102 using semiconductor processes that include the growth of the undoped layer 120 (e.g., u-GaN layer), the n-type layer 122 (e.g., Si doped GaN layer), the active layers 124 (e.g. multiple quantum wells), and the p-type layer 126 (e.g. Mg doped GaN layer). However, these materials are merely exemplary, and the epitaxial structure 112 can be formed of other direct bandgap compound semiconductor light emitting diode materials grown on the growth substrate 102. For example, the emitting wavelength of semiconductor light can be determined by the energy bandgap of a direct bandgap semiconductor compound. Different direct energy bandgaps of the semiconductor light emitting material can be selected from III-V compound semiconductors, such as InₓGa₁₋ₓN, GaN, AlₓGa₁₋ₓN, InₓGa₁₋ₓAs, InGaP, GaAs, GaAsP, InP, (AlₓGa₁₋ₓ)_{y}In_{1-y}P, GaP.

The isolation layer 101 can comprise a continuous layer formed of a dielectric material, such as SiO₂, Si₃N₄, Al₂O₃ or TiO₂ formed to a uniform thickness using a suitable deposition process such as CVD, PECVD, spin-on or deposition through a nozzle. A representative thickness of the isolation layer 101 can be from 2000 A to 500 µm. As shown in Figure 1, the isolation layer 101 can be deposited on a top portion of the p-type layer 126, and on the sidewalls of the p-type layer 126. In addition, the isolation layer 101 can be deposited on the sidewalls of the active layer 124, on the sidewalls of the n-type layer 122, on the sidewalls of the undoped layer 120 and on a portion of the exposed growth substrate 102 in the street region 136. Also note that the corner 111 of the isolation layer 101 is located between the undoped layer 120 of the sidewall 140 of the light emitting diode (LED) structure 100 and the surface of the growth substrate 102. In addition, the isolation layer 101 is conformally deposited on the corner 111 with a right angle, and can be deposited on either portion of the street regions 136 or on the entire street regions 136.

As also shown in Figure 1, a mesa surround structure 201 can be formed to provide a spacing of the sidewall P-N junctions 138 away from the sidewalls 140 of the light emitting diode (LED) structure 100. This spacing functions to extend the length of the isolation layer 101. With the mesa surround structure 201, the isolation layer 101 extends from vertical connections at the sidewalls 140 of the light emitting diode (LED) structures 100 to a horizontal connection at the mesa surround structures 201 and then turns to the vertical connection at the sidewall P-N junctions 138. The different directions of the isolation layer 101 can be provided using a different speed/rate of chemical etching.

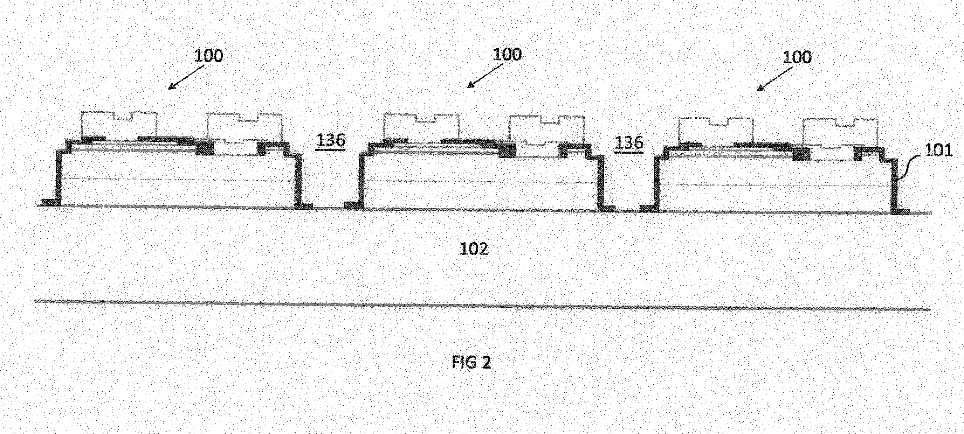

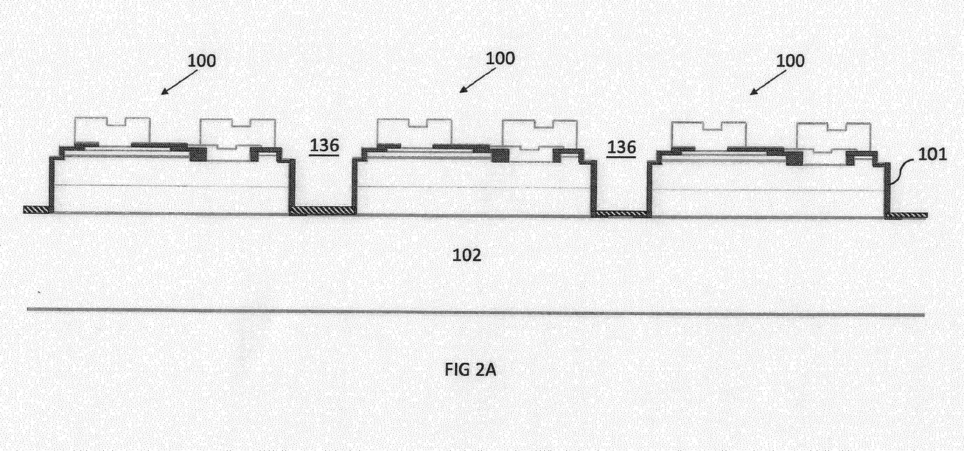

As shown in Figure 2, the growth substrate 102 can include a plurality of light emitting diode (LED) structures 100 separated by the street regions 136. Figures 2 and 2A illustrate two different configurations for the isolation layer 101 on the growth substrate 102. In Figure 2, the isolation layer 101 does not continue into the street regions 136. In Figure 2A, the isolation layer 101 continues into the street regions 136.

The light emitting diode (LED) structures 100 shown in Figure 1, Figure 2 and Figure 2A, have the configuration of conventional flip chip light emitting diodes (FCLEDs). In each light emitting diode (LED) structure 100, the p-type conductive layer 130 can be combined by using multiple conductive layers such as a p-type ohmic contact layer to the p-type layer 126 followed by additional p-metal layers as required. For example, a p-type ohmic contact layer can comprise ITO, Ni, Ag, Au, Pt, Pd or alloys of these metals. The p-type conductive layer 130 can comprise Cr, Ni, A1, Au, Cu, Ti, W, TiN or alloys of these metals. The n-type conductive layer 128 can comprise Cr, Al, Ti, Ni, Au or alloys of these metals. The p-pad 132 can be electrically conductive to the p-type layer 126 and the n-pad 134 can be electrically conductive to the n-type layer 122.

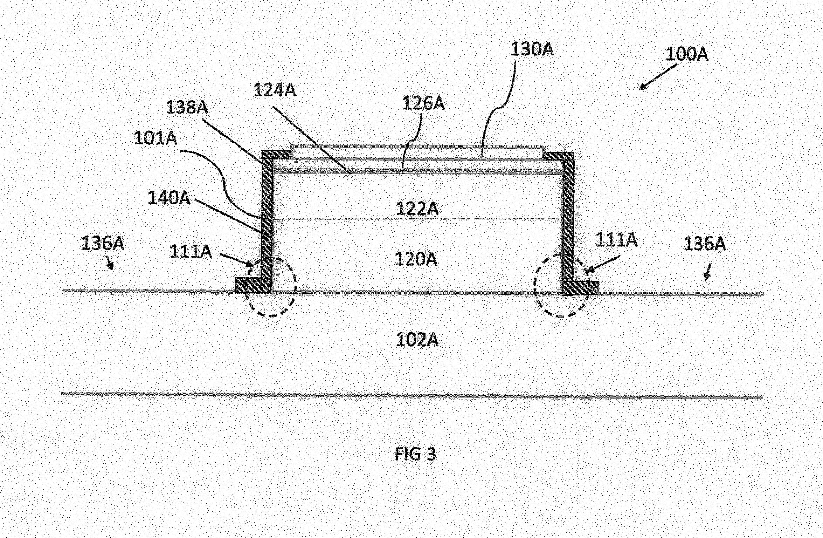

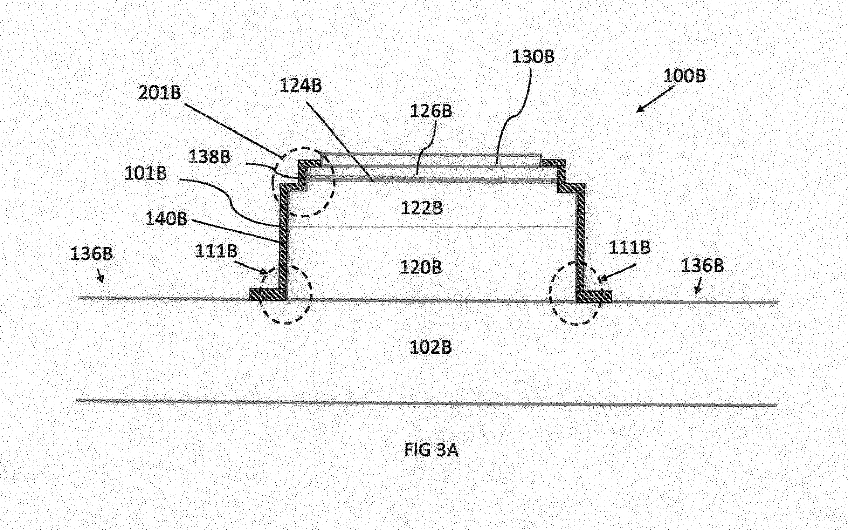

Referring to Figure 3, a vertical light emitting diode (VLED) structure 100A has the configuration of a vertical light emitting diode (VLED) chip. The vertical light emitting diode (VLED) structure 100A includes an undoped layer 120A, an n-type layer 122A, an active layer 124A, and a p-type layer 126A arranged substantially as shown. As before, in accordance with the present method, an isolation layer 101A having corners 111A has been formed on the p-type layer 126A, and on a portion of the growth substrate 102A, substantially as previously described. In the vertical light emitting diode (VLED) structure 100A of Figure 3, the isolation layer 101A can also be formed on the sidewalls 140A of the vertical light emitting diode (VLED) structure 100A and on the sidewalls of the P-N junction 138A as well.

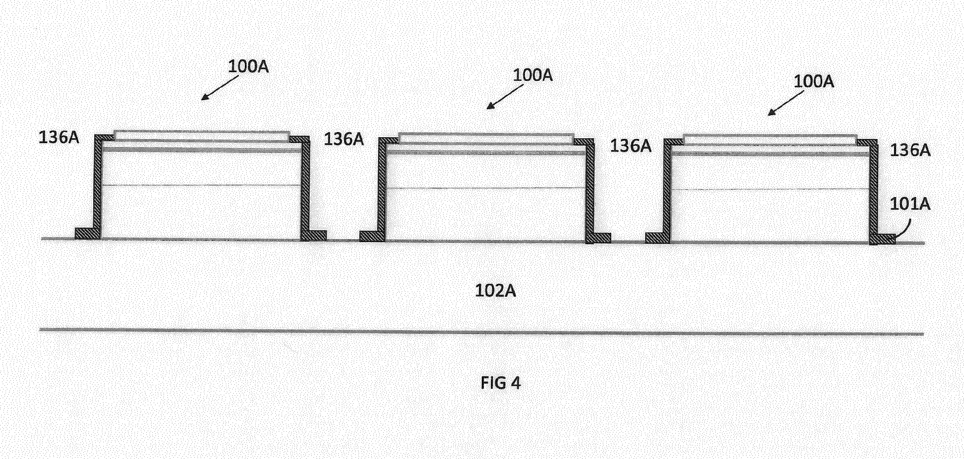

Referring to Figure 3A, a vertical light emitting diode (VLED) structure 100B has the configuration of a vertical light emitting diode (VLED) chip on a growth substrate 102B constructed substantially as previously described for vertical light emitting diode (VLED) structure 100A (Figure 3). However, the vertical light emitting diode (VLED) structure 100B also includes a mesa surround structure 201B constructed substantially as previously described for mesa surround structure 201 (Figure 1). With the mesa surround structures 201 (Figure 1) and 201B (Figure 3A), a sidewall P-N junction 138B is spaced away from the sidewalls 140B of the vertical light emitting diode (VLED) structure 100B. As before, an isolation layer 101B having a corner 111B has been formed on the sidewalls 140B of the VLED chip, on the mesa surround structure 201B and on the sidewall P-N junction 138B. In Figure 3 and Figure 3A, a p-type conductive layer 130A (Figure 3), 130B (Figure 3A) can comprise ITO, Ni, Ag, Au, Pt, Pd or alloys of these metals. In Figure 4, a plurality of vertical light emitting diode (VLED) structures 100A have been formed on the growth substrate 102A, and the isolation layer 101A does not continue into the street regions 136A.

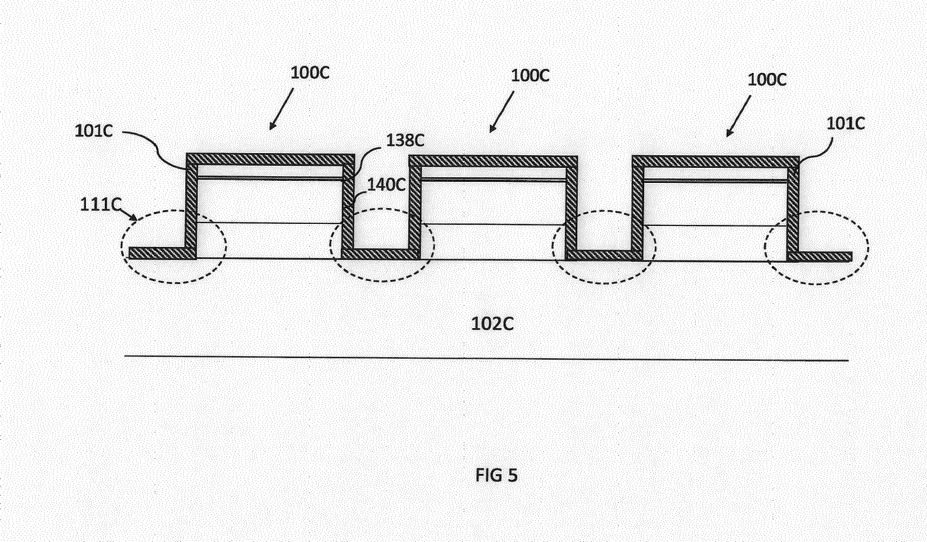

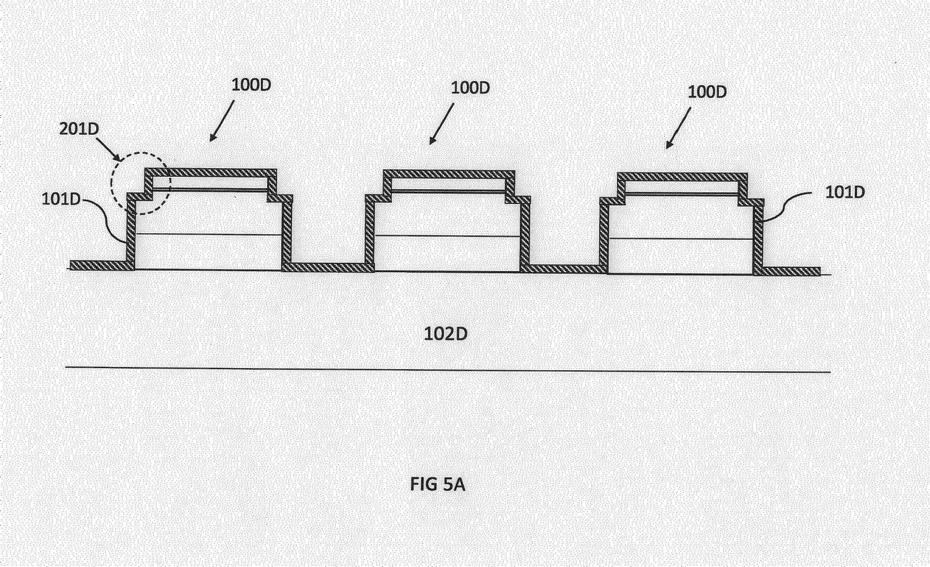

Referring to Figures 5-10, further steps in the method for fabricating semiconductor light emitting devices (LEDs) are illustrated. In Figure 5, an isolation layer 101C has been formed on a plurality of vertical light emitting diode (VLED) structures 100C on a growth substrate 102C and includes corners 111C on the intersection of the vertical light emitting diode (VLED) structures 100C and the growth substrate 102C substantially as previously described. Figure 5A is another embodiment wherein an isolation layer 101D has been formed on a plurality of vertical light emitting diode (VLED) structures 100D with mesa surround structures 201D on a growth substrate 102D. The isolation layer 101C (Figure 5) or isolation layer 101D (Figure 5A) can be conformably formed on the vertical light emitting diode (VLED) structures 100C to a uniform thickness using a suitable deposition process such as CVD, PECVD, spin-on or deposition through a nozzle. As shown in Figure 5, the isolation layer 101C covers the sidewalls 140C containing P-N sidewall junctions 138C and maintains the isolation of the vertical light emitting diode (VLED) structures 100D from one another on the growth substrate 102C.

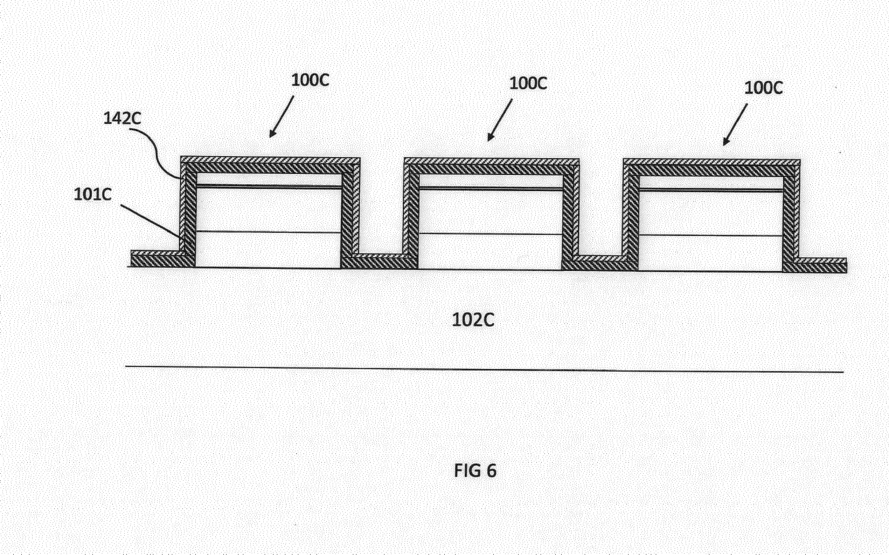

Referring to Figure 6, following forming of the isolation layer 101C, an etchable covering channel layer 142C can be formed on the isolation layer 101C. The covering channel layer 142C can comprise an etchable material including a metal, such as Ti, or an oxide, such as SiO₂.

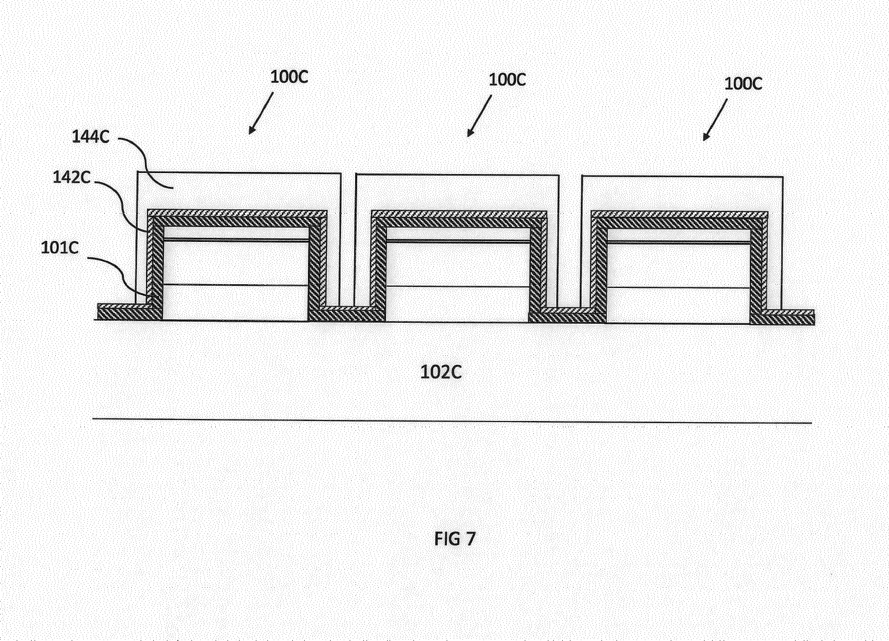

Referring to Figure 7, following forming of the covering channel layer 142C, a patterning protection layer 144C can be formed on the covering channel layer 142C. The patterning protection layer 144C can comprise a patternable material such as photoresist.

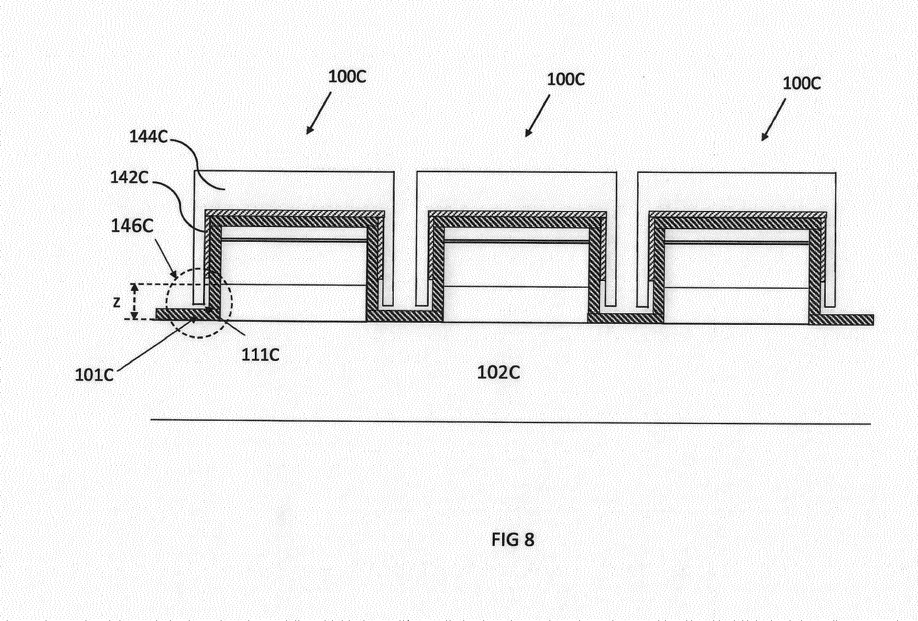

Referring to Figure 8, following forming of the patterning protection layer 144C, etching channels 146C can be formed in the covering channel layer 142C using a first chemical etching process. The etching channels 146C are located on the corners 111C and can be shaped and sized with dimensions, such as a height z on the growth substrate 102C, to surround the corners 111C for removal by a second chemical etching step. The patterning protection layer 144C includes openings formed using photolithography that determine the location, shape and size of the etching channels 146C. In an exemplary embodiment, the first chemical etching process can be performed using an etcher chemical solution for metal to provide selective wet etching for removing portions of a covering channel layer 142C comprised of a metal (e.g., Ti).

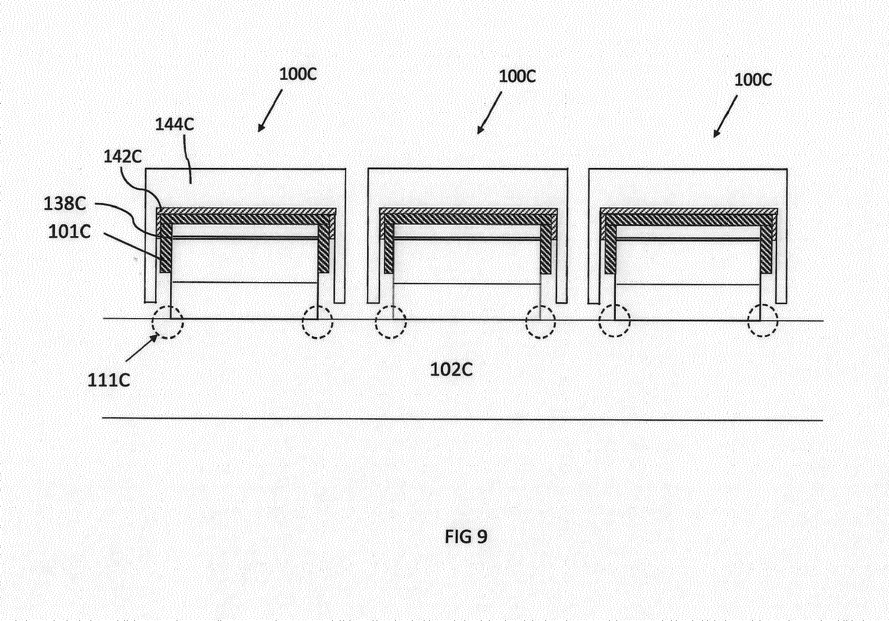

Referring to Figure 9, following forming of the etching channels 146C, the corners 111C of the isolation layer 101C can be removed by etching the isolation layer 101C using a second chemical etching process. In an exemplary embodiment, the isolation layer 101C can comprise SiO₂ and the second chemical etching process can be performed using a BOE etch. Note that during this step, the isolation layer 101C is only removed at the corner 111C leaving the isolation layer 101C covering the sidewall P-N junction 138C.

In another embodiment, the isolation layer 101C can comprise Si₃N₄ and the covering channel layer 142C can comprise SiO₂. For a BOE chemical etching, the etching rate of the Si₃N₄ is slower than that of the SiO₂ (e.g., etching SiO₂ 500 nm in BOE takes only a few seconds, but etching Si₃N₄ 500 nm in BOE needs a few minutes). Thus, for the first-time etching process, a SiO₂ covering channel layer 142C can be removed faster than that of the Si₃N₄ isolation layer 101C thus forming an etching channel 146C. By etching for a longer time in the same BOE solution, the Si₃N₄ isolation layer 101C at the corner 111C can be removed. Please note that the method functions to remove only the isolation layer 101C at the corner 111C, leaving the isolation layer 101C at the sidewall P-N junction 138C protected and unetched.

In embodiments, such as vertical light emitting diode (VLED) structure 100B (Figure 3A) having the mesa surround structure 201B (Figure 3A), and vertical light emitting diode (VLED) structures 100D (Figure 5A) having mesa surround structures 201D (Figure 5A), the mesa surround structures 201B (Figure 3A) or 201D (Figure 5A) function as structures to slow down the etching speed/rate. In these embodiments, the covering channel layer 142C (Figure 7) and the isolation layer 101B (Figure 3A) or 101D (Figure 5A) have a turn direction of etching from a vertical direction to a horizontal direction. The mesa surround structures 201B (Figure 3A) or 201D (Figure 5A) take advantage of the concept of the etching rate for a target etching layer having different etching speed/rate at different directions. For some applications, the mesa surround structures 201B (Figure 3A) or 201D (Figure 5A) can be fabricated as multiple mesas structures (similar to be stairs) if needed, as a geometrical control of the etching conditions.

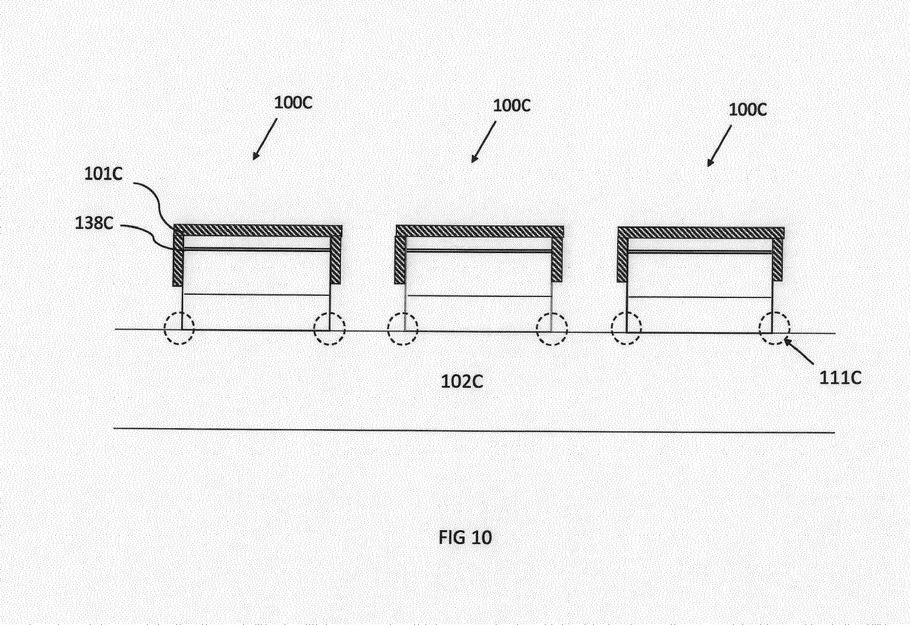

Referring to Figure 10, following etching of the isolation layer 101C, the covering channel layer 142C and the patterning protection layer 144C can be removed. Depending on the materials, these layers can be removed using techniques that are known in the art.

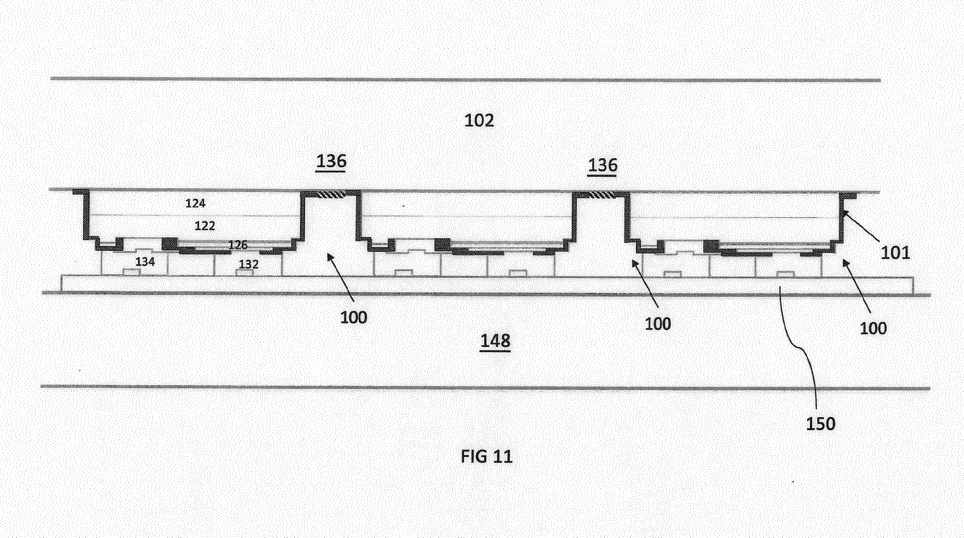

Referring to Figure 11, the method can also include a step of bonding the growth substrate 102 to a carrier 148 having an elastic polymer material 150 thereon. The bonding step is part of a laser lift off (LLO) process to be further described. The bonding step can be performed by flip chip bonding the light emitting diode (LED) structures 100 to the carrier 148.

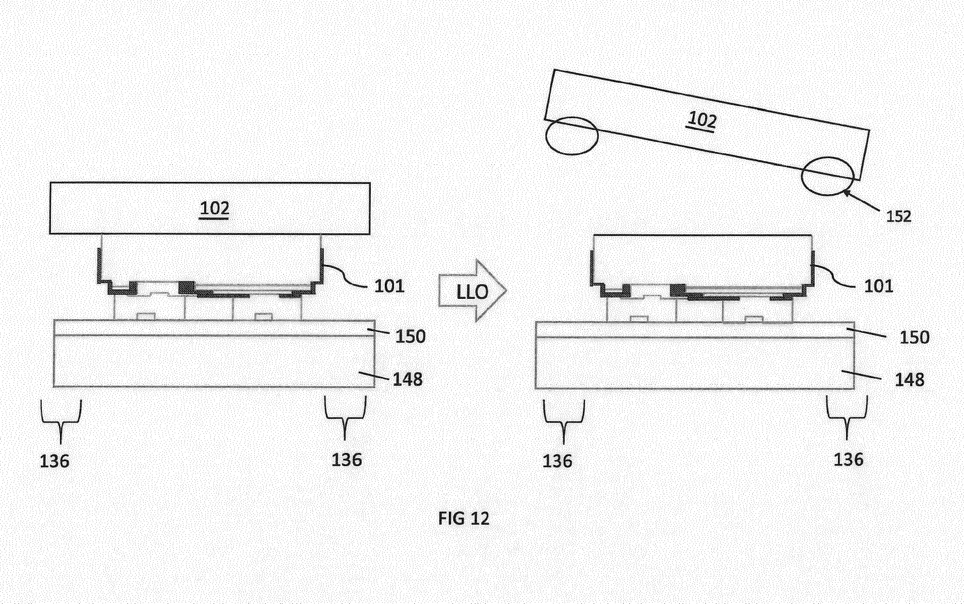

Referring to Figure 12, the method can also include a laser lift off (LLO) step wherein the growth substrate 102 is separated from the light emitting diode (LED) structures 100 using a laser lift off process. US Publication No.: US 2021/0066541 to Chu et al., which is incorporated herein by reference, discloses a laser lift off process (LLO), and the above described bonding step. In one embodiment, the corners 111 of the isolation layer 101 have been removed. The original isolation layer 101 on the corner areas 152 cannot be damaged to leave a partial isolation layer peel (not shown) on the growth substrate 102. In addition, the present (LLO) step transmits the light emitting diode (LED) structures 100 to the carrier 148 without damaging isolation layer 101 on the sidewall P-N junction 138 (Figure 1). This produces robust light emitting diode (LED) structures 100 for different applications. In addition, the street regions 136 of the carrier 148 remain clean (no isolation residue).

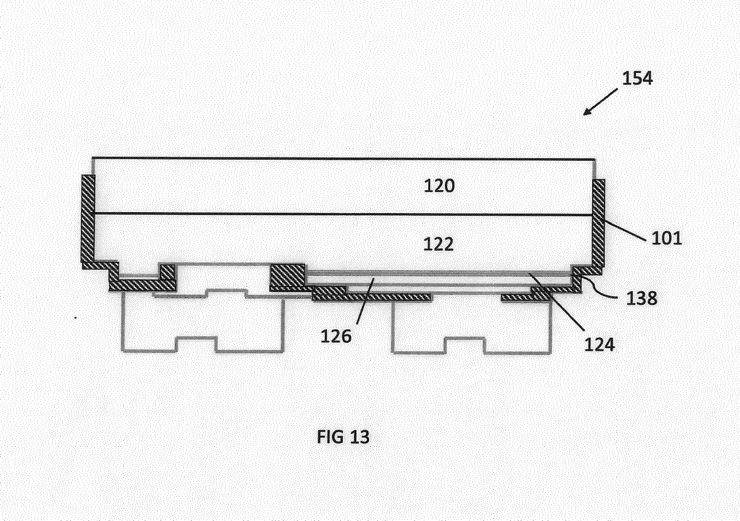

Referring to Figure 13, a semiconductor light emitting device (LED) 154 fabricated using the method is illustrated. The semiconductor light emitting device (LED) 154 includes the isolation layer 101 covering the sidewall P-N junction 138. In addition, the isolation layer 101 covers a sidewall of the p-type layer 126 (Figure 1), a sidewall of the active layers 124 (Figure 1), and a portion of a sidewall of the n-type layer 122 (Figure 1) leaving the undoped layer 120 (Figure 1) exposed. In some cases, the isolation layer 101 covers a sidewall of the p-type layer 126, a sidewall of the active layers 124, a sidewall of the n-type layer 122 and a portion of the undoped layer 120, leaving the other portion of the undoped layer 120 exposed.

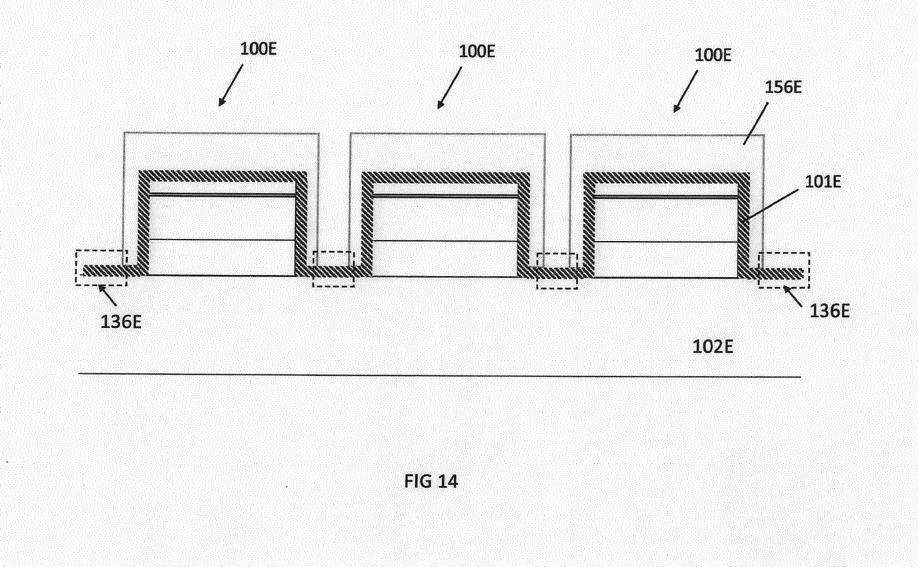

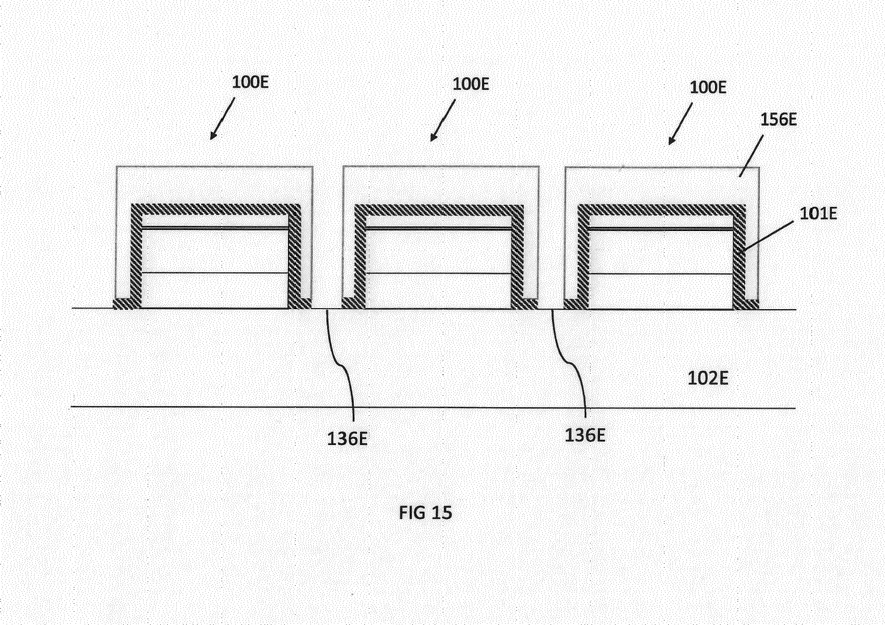

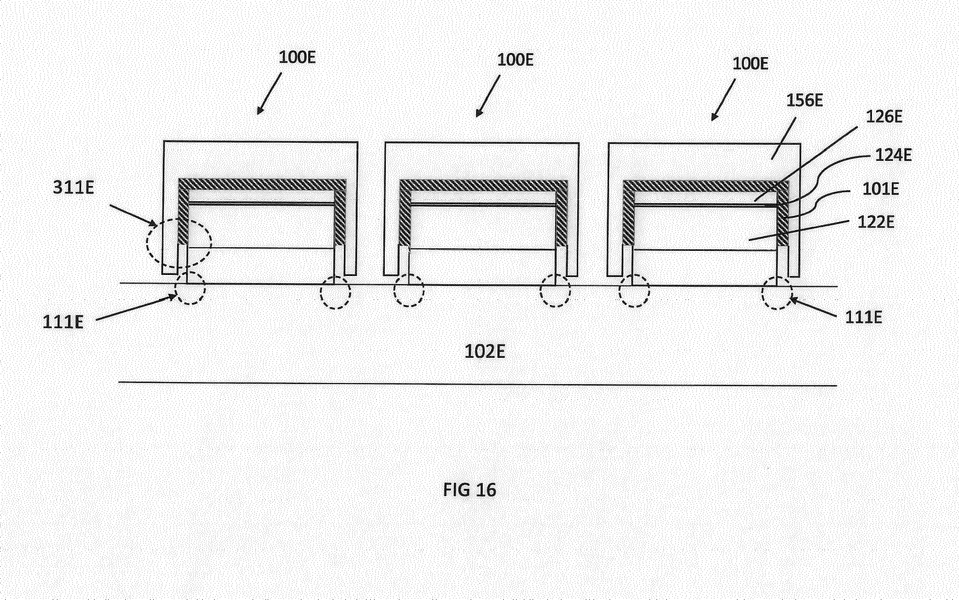

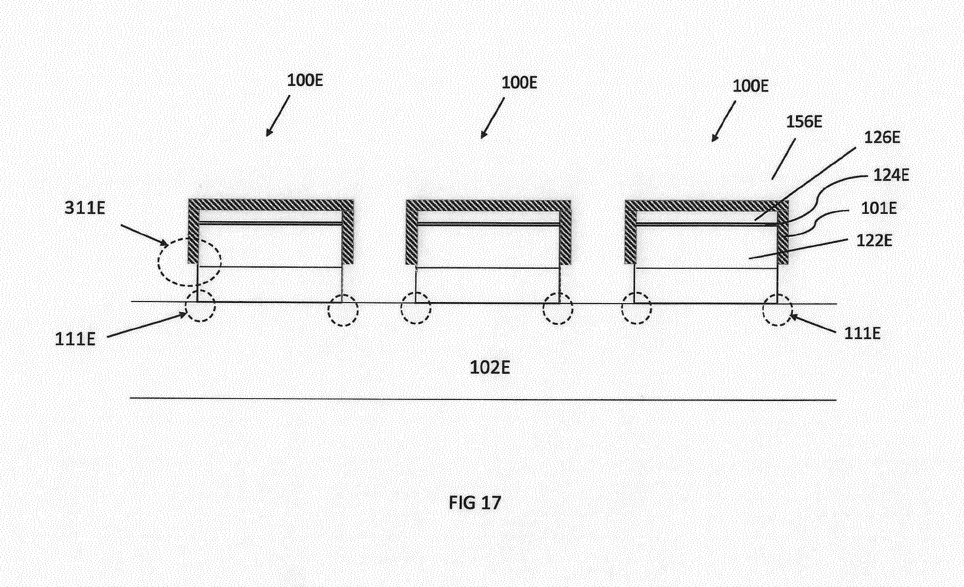

Referring to Figures 14-17, an alternate embodiment method for removing an isolation layer 101E in the street regions of a growth substrate 102E and forming an undercut sidewall structure 311E are illustrated. In Figure 14, a patterning protection layer 156E has been deposited and patterned to cover light emitting diode (LED) structures 100E and portions of the isolation layer 101E on the street regions 136E of the growth substrate 102E. Figure 15 illustrates portions of the isolation layer 101E on the street region 136E have removed by a dry etching process or a chemical etching process. For applications requiring anisotropic structures, a dry etching process can be used to remove the isolation layer 101E on the street region 136E. Figures 16 and 17 illustrate the undercut sidewall structure 311E formed by wet etching to remove portions of the isolation layer 101E on the street region 136E. A wet chemical solution such as BOE can applied to start the wet etching on portions of the isolation layer 101E on the exposed sidewall of the light emitting diode (LED) structures 100E. By controlling the etching time and preventing the over-etching of the isolation layer 101E to the active layer 124 (Figure 1), the undercut sidewall structure 311 can be formed. Figure 16 shows the undercut sidewall structure 311. In addition, the isolation layer 101E is etched at the corner 111E, but the isolation layer 101E still covers a portion of the n-type layer 122E, the active layers 124E and the p-type layers 126E. This feature enhances reliability and prevents current leakage in the light emitting diode (LED) structures 100E. In Figure 17 the patterning protection layer 156E has been removed.

### Example (Method)

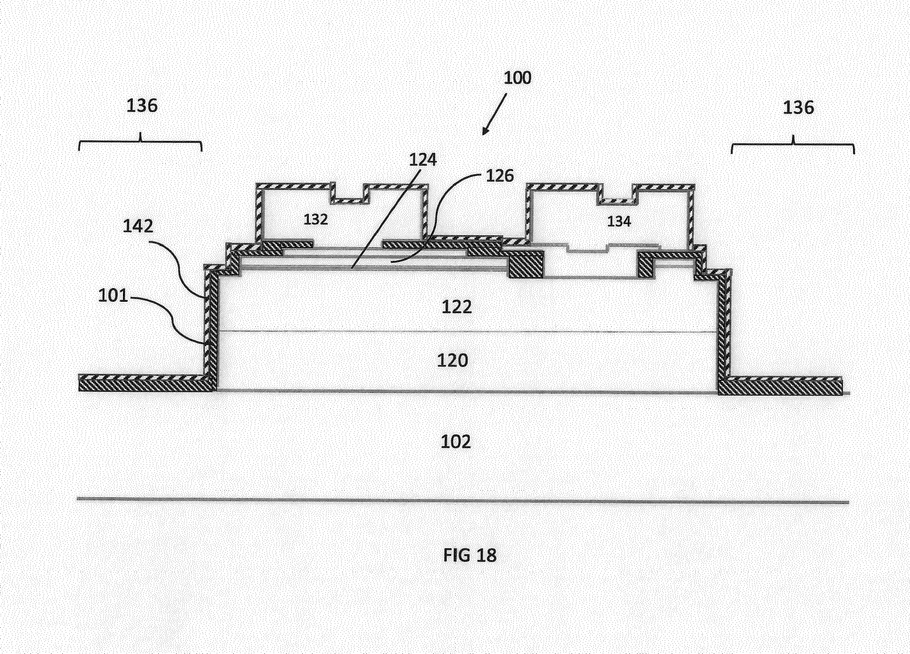

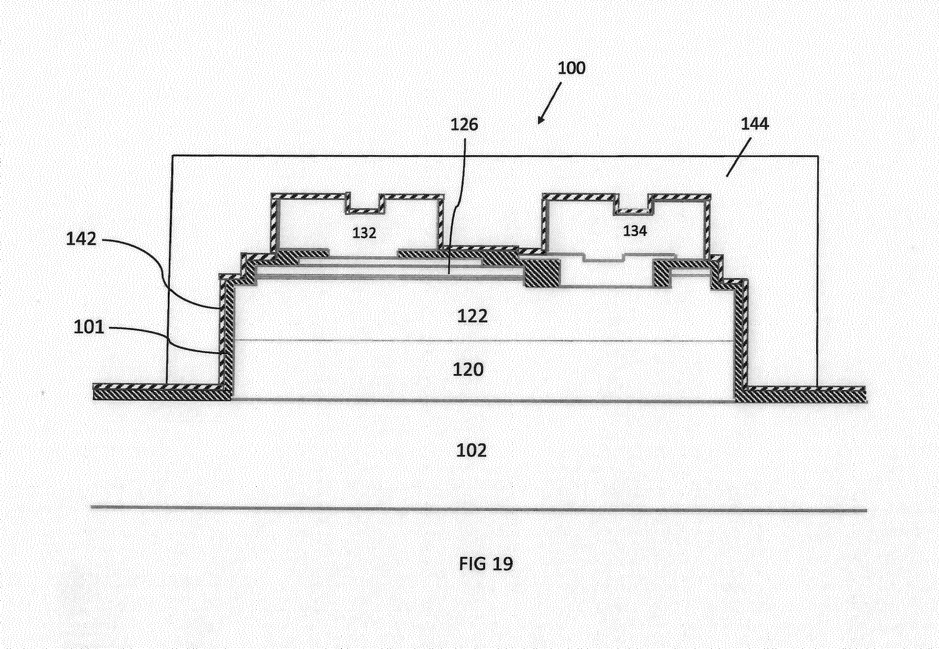

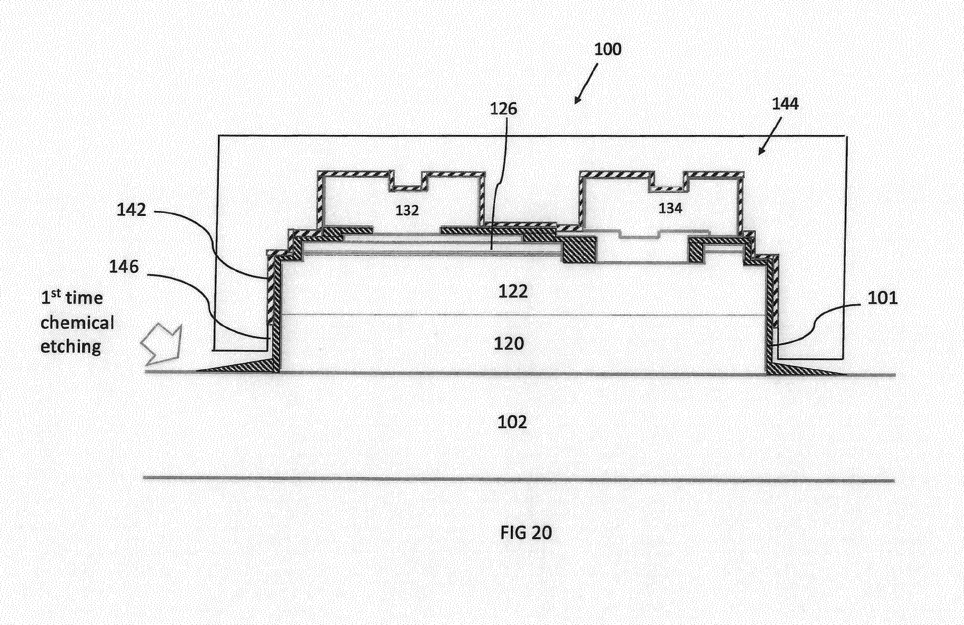

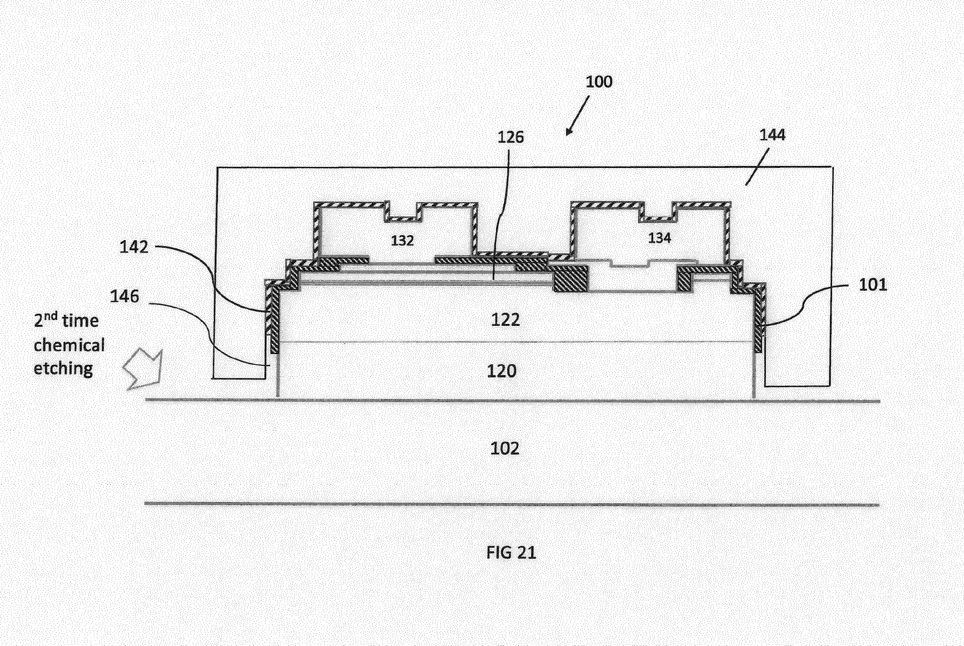

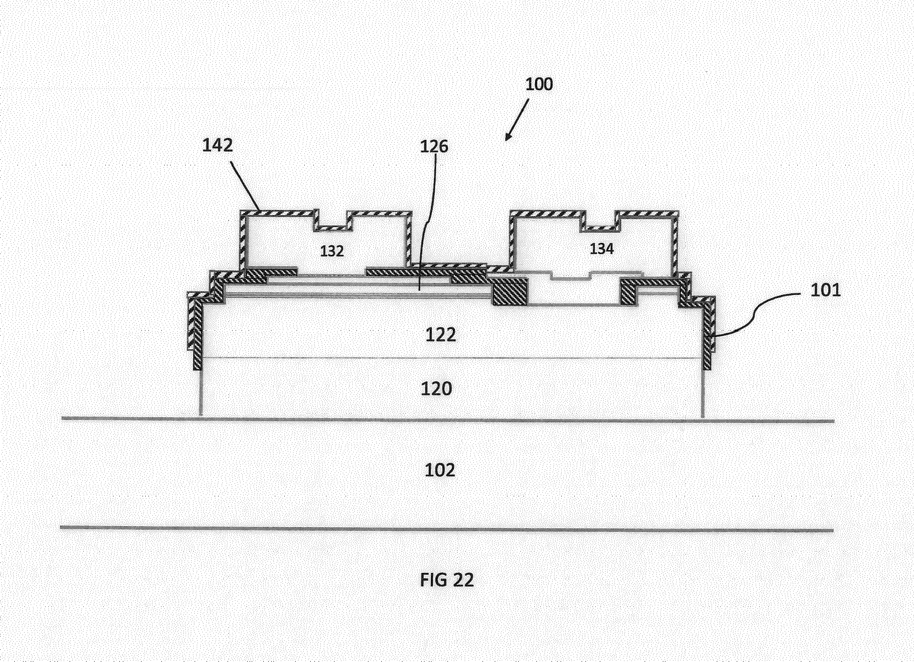

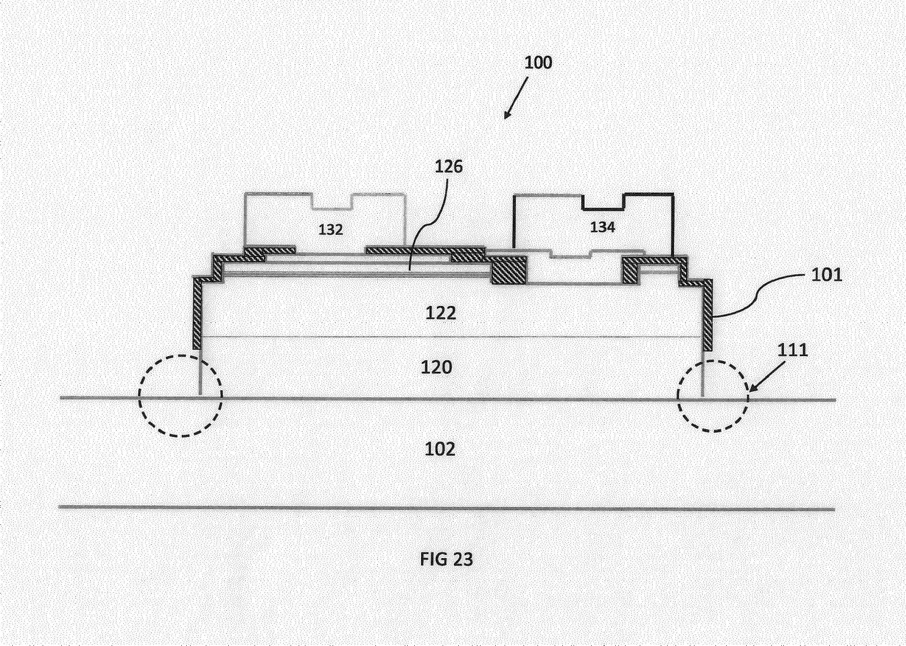

Referring to Figures 18-23, further aspects of the method are illustrated in an example. In Figure 18, a covering channel layer 142 has been conformally deposited on the light emitting diode (LED) structure 100 (Figure 1). The isolation layer 101 comprises SiO₂ (5000A) and the covering channel layer 142 comprises Ti (2000A). Figure 19 illustrates a patterning protection layer 144 formed of photoresist patterned to cover the light emitting diode (LED) structure 100. Figure 20 illustrates a first etching process (e.g., dilute BOE) to remove a portion of the covering channel layer 142 and form an etching channel 146. Note that the SiO₂ isolation layer 101 at the corner 111 is partially removed by the first-time etching (e.g., dilute BOE). Figure 21 illustrates a second etching process in the same dilute BOE solution, the Ti covering channel layer 142 is further etched and the isolation layer 101 at the corner 111 has been removed. Figure 22 illustrates the patterning protection layer 144 has been removed. Figure 23 shows the Ti covering channel layer 142 has been removed/etched using a Ti etcher (i.e., does not etch the SiO₂). Note that the corner 111 of the light emitting diode (LED) structure has no isolation layer 101.

### Example (Alternate Embodiment Method)

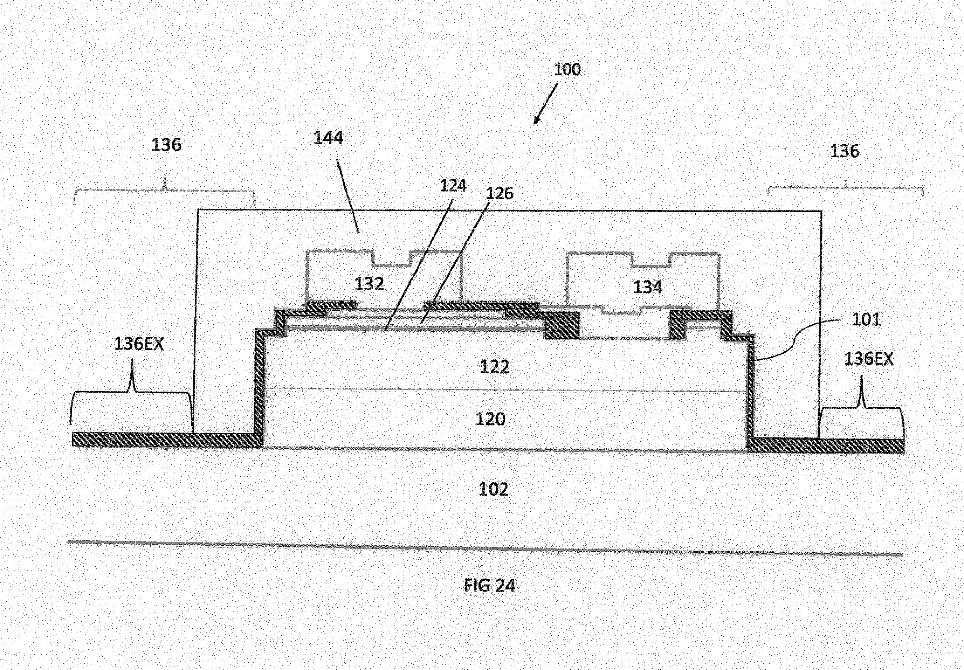

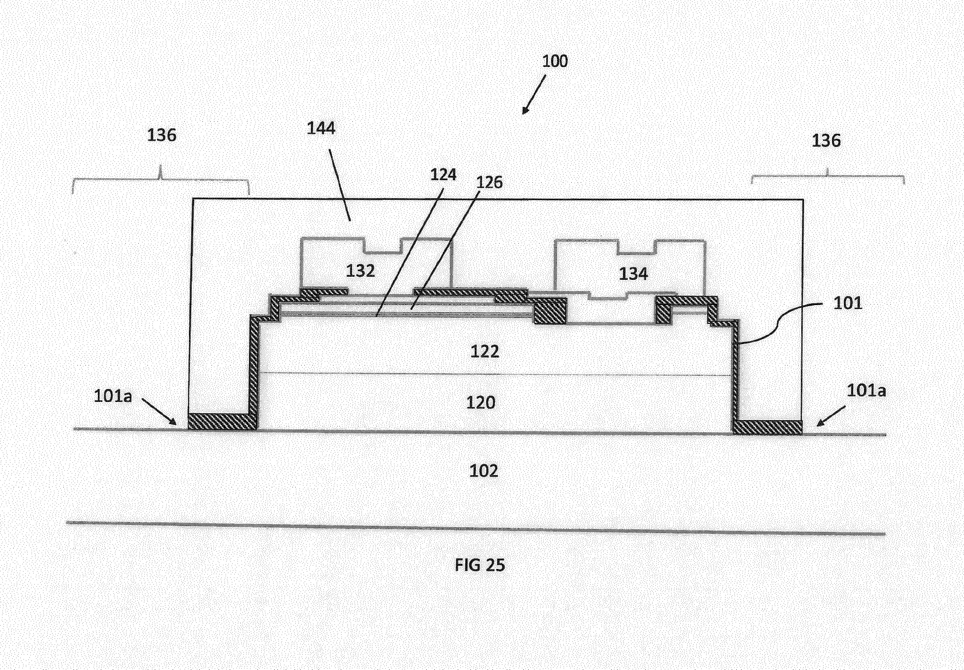

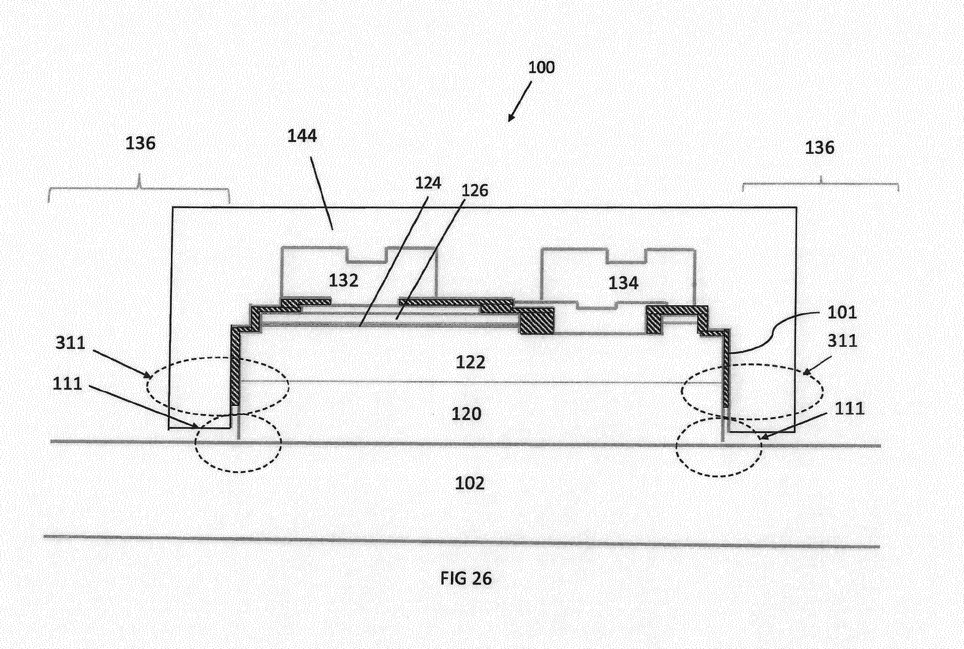

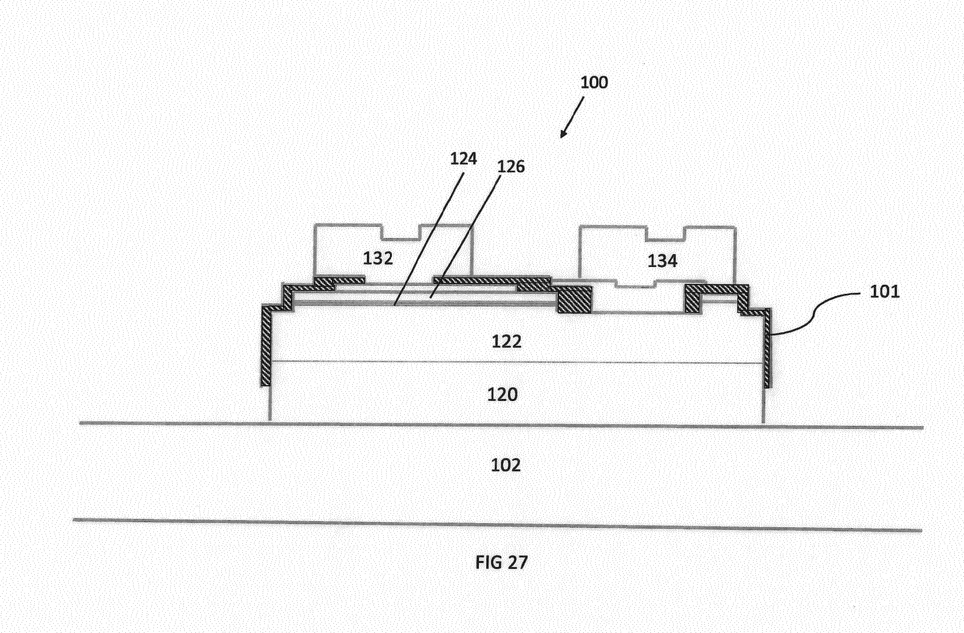

Referring to Figures 24-27, further aspects of the alternate embodiment method are illustrated in an example. In Figure 24 a patterning protection layer 144 covers light emitting diode (LED) structure 100 and a portion of the isolation layer 101 on the street regions 136 of the growth substrate 102. The isolation layer 101 is exposed in an exposed street region 136EX. In Figure 25, the exposed isolation layer 101 at exposed street region 136EX can be etched using a dry etching process. Figure 26 illustrates, a wet chemical solution such as BOE can be applied to start the wet etching from the exposed sidewall isolation layer 101a. The wet chemical solution is configured to etch the isolation layer 101 underneath the patterning protection layer 144. The etching time is controlled to prevent the over etching of the isolation layer 101 to the active layers 124. Figure 26 also shows an undercut sidewall etching structure 311 and with the isolation layer 101 removed at the corner 111. However, the isolation layer 101 still covers a portion of the n-type layer 122, the active layers 124, and the p-type layer 126. In Figure 27 the patterning protection layer 144 has been removed.

### Example (One Embodiment Of The Laser Lift Off (LLO) Process)

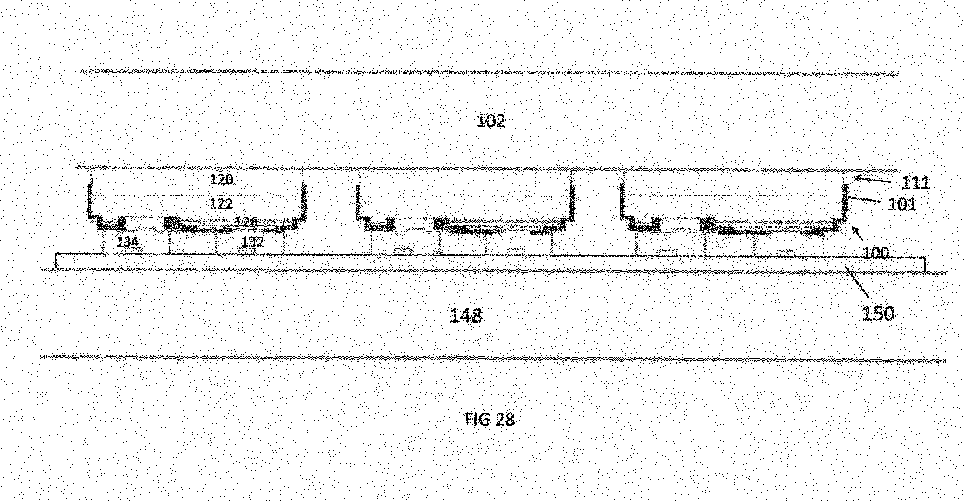

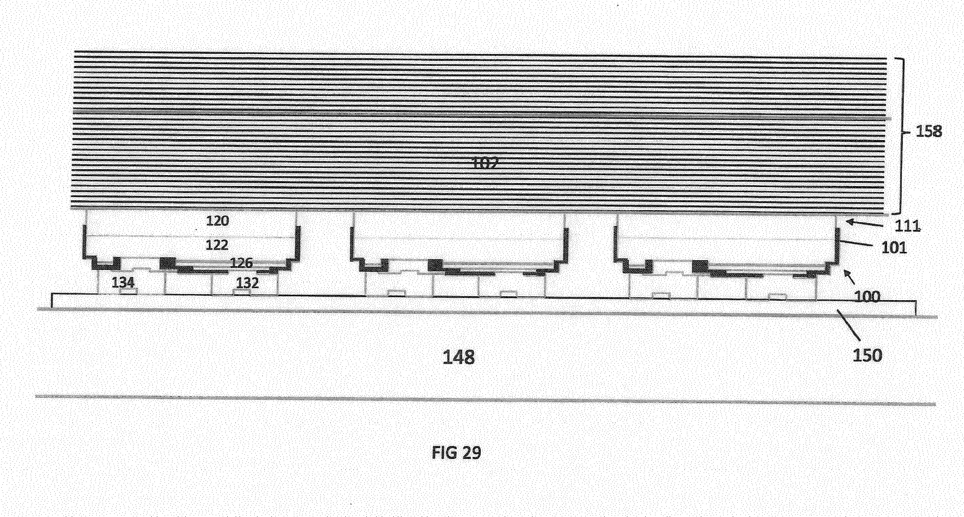

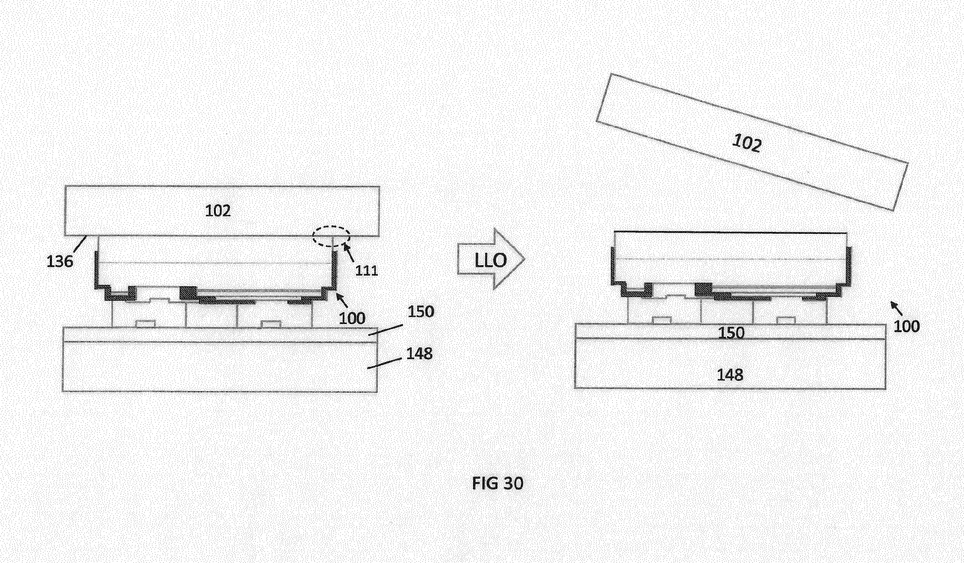

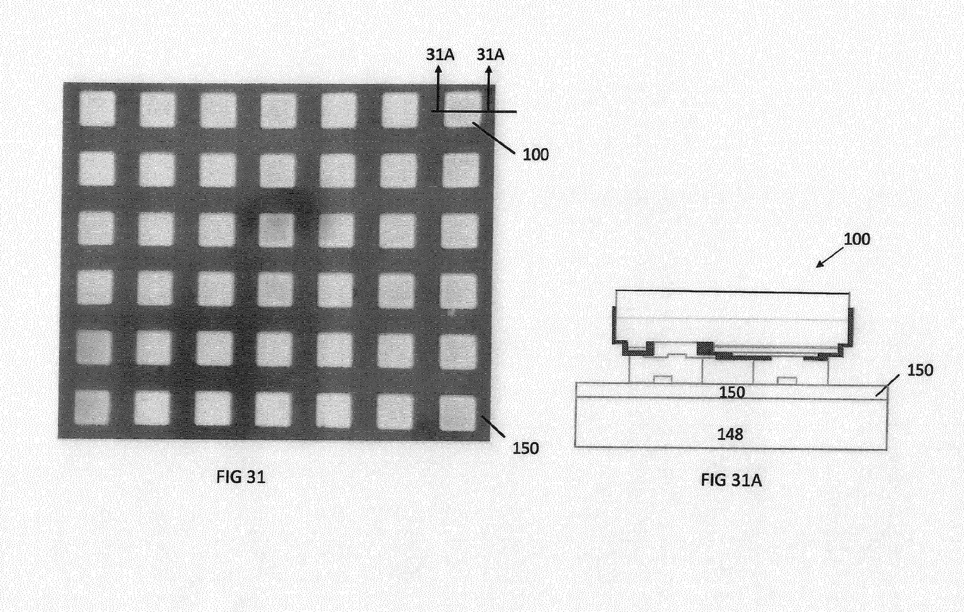

Referring to Figures 28-30, further aspects of the laser lift off (LLO) process are illustrated. As shown in Figure 28, the corner 111 of the isolation layer 101 has been removed from the light emitting diode (LED) structures 100 by using the method or the alternate embodiment method. Figure 29 illustrates a laser beam 158 used to perform the LLO process. Figure 30 illustrates that there is no isolation residue (i.e., no SiO₂ residue on the growth substrate 102 in the street regions 136 and no SiO₂ peeled residue on the elastic polymer material 150 in the street region 136). Figure 31 and Figure 31A also illustrate the lack of SiO₂ residue on the carrier 148.

### Example (Prior Art Laser Lift Off (LLO) Process)

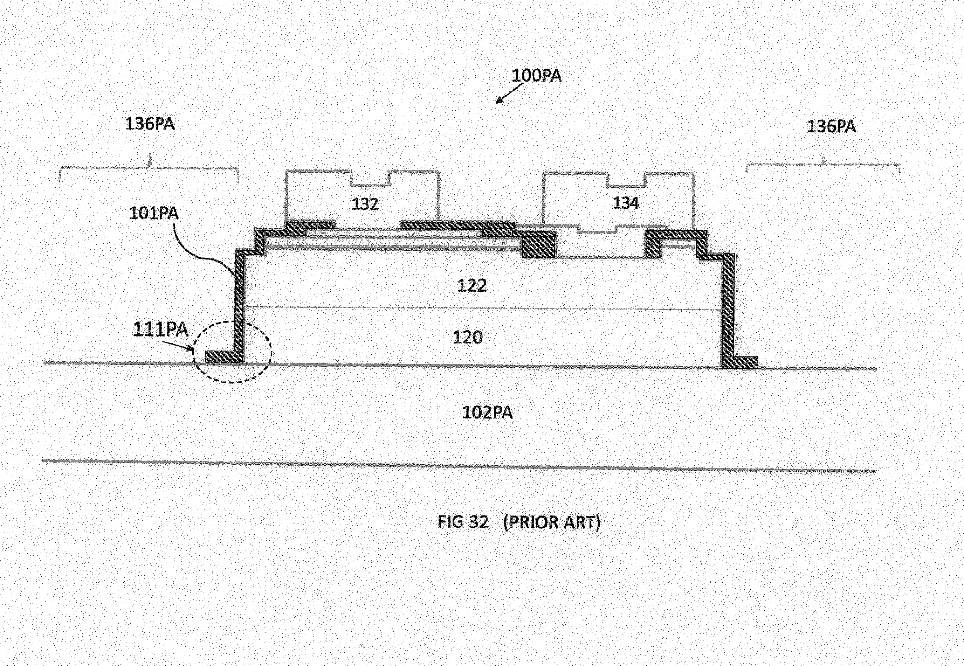

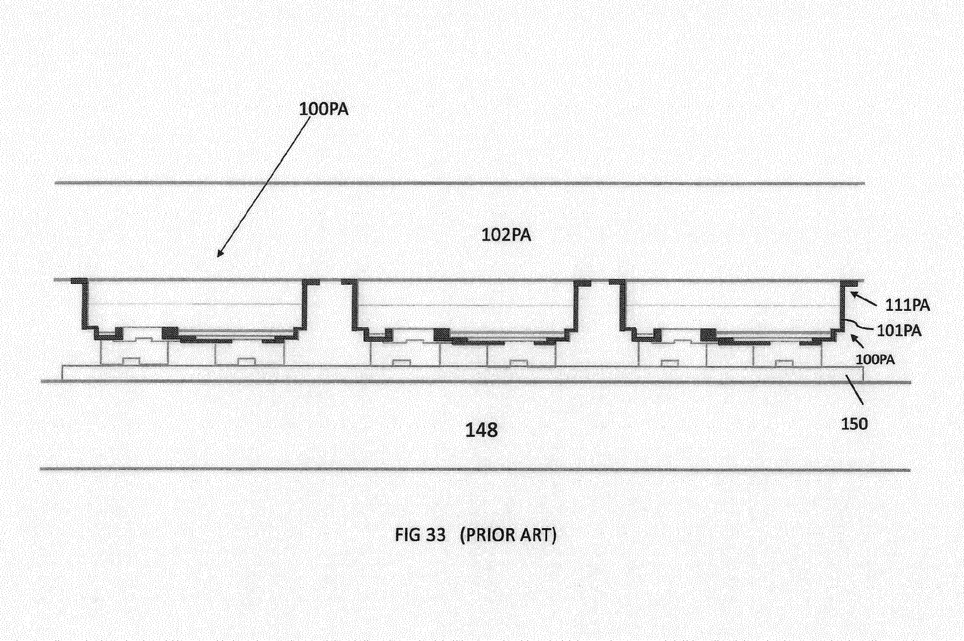

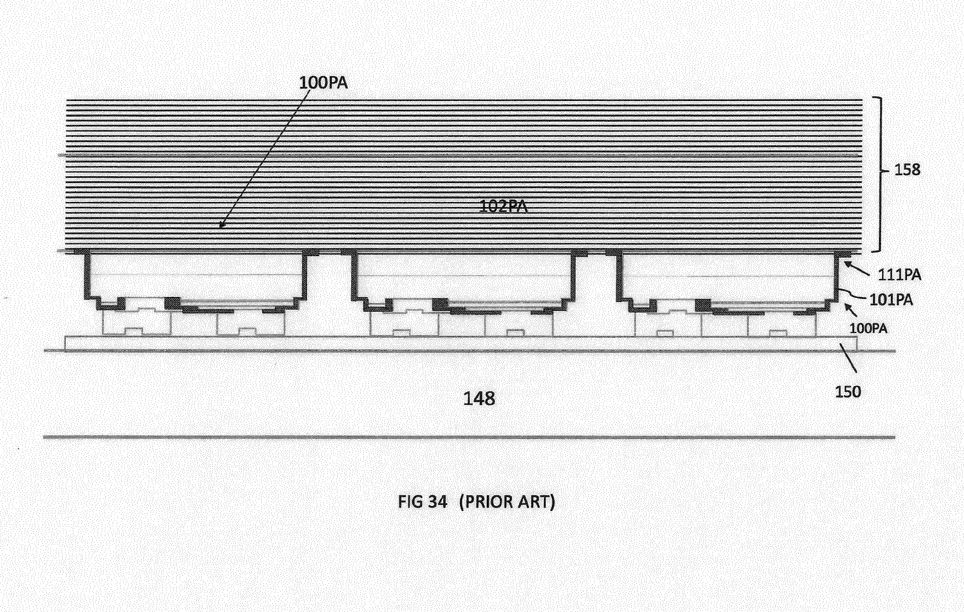

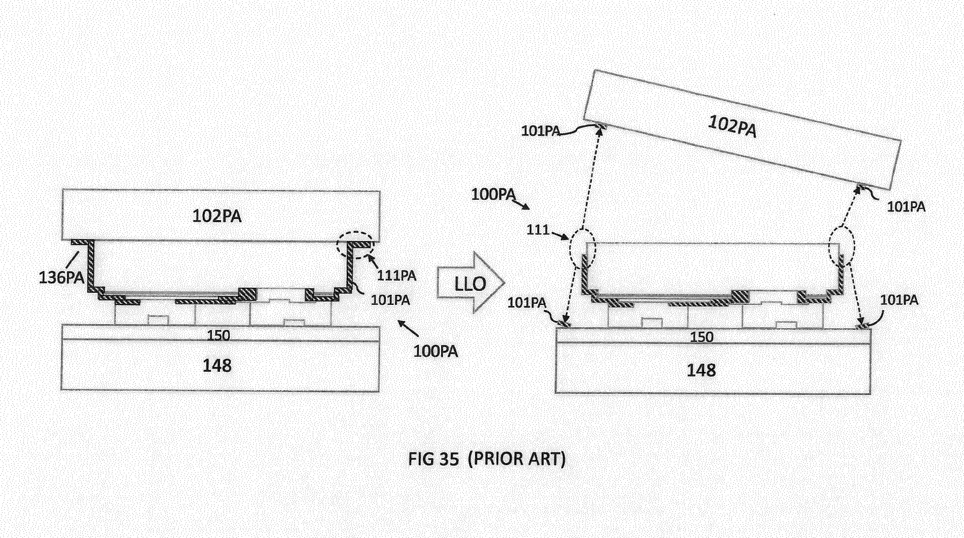

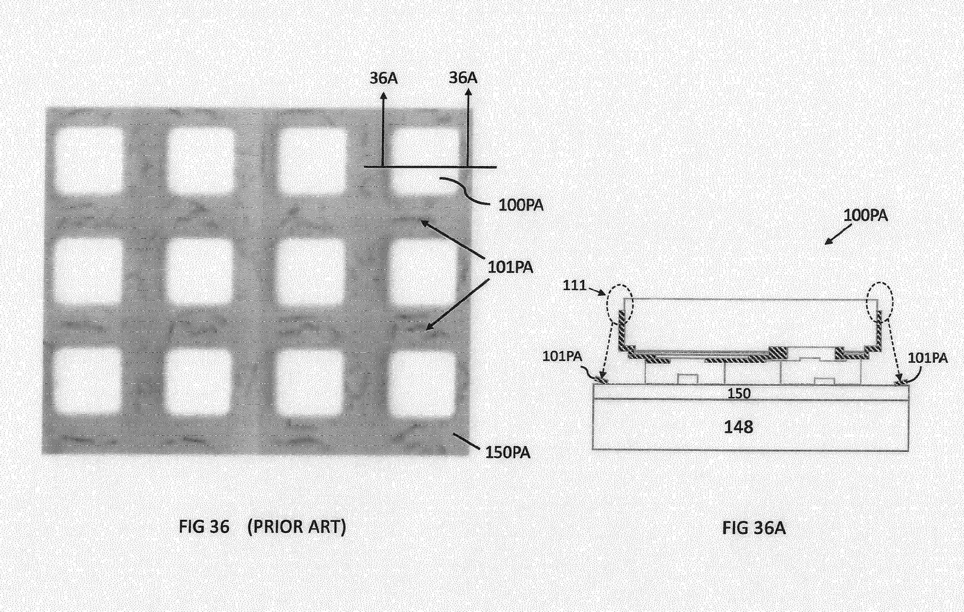

Referring to Figures 32-36, aspects of a prior art laser lift off (LLO) process for fabricating prior art light emitting diode (LED) structures 100PA, are illustrated. Figure 32 illustrates a conventional flip chip light emitting diode (LED) structure 100PA on a sapphire growth substrate 102PA. A portion of an isolation layer 101PA remains on the street regions 136PA and the corner 111PA after a conventional chip fabrication process. Figure 33 illustrates a wafer form of the conventional flip chip light emitting diode (LED) structures 100PA on the growth substrate 102PA flipped and bonded to a carrier 148 having an elastic polymer material 150. A corner 111PA of the isolation layer 101PA remains on the street regions 136PA of the growth substrate 102PA. Figure 34 illustrates a laser beam 158, the carrier 148 and the elastic polymer material 150, as previously described, used to perform the (LLO) process. Figure 35 illustrates that there may be isolation residue 101PA (e.g., SiO₂ residue) on the growth substrate 102PA in the street regions 136PA and peeled isolation residue 101PA (e.g., SiO₂ residue) on the elastic polymer material 150 in the street region 136PA. Figure 36 and Figure 36A also illustrate the isolation residue 101PA (e.g., SiO₂ residue) on the elastic polymer material 150 of the carrier 148. The present method eliminates the isolation residue 101PA to provide more reliable and robust light emitting diode (LED) structures 100 (Figure 2).

While a number of exemplary aspects and embodiments have been discussed above, those of skill in the art will recognize certain modifications, permutations, additions and subcombinations thereof. It is therefore intended that the following appended claims and claims hereafter introduced are interpreted to include all such modifications, permutations, additions and sub-combinations as are within their true spirit and scope.

## Claims

1. A method for fabricating semiconductor light emitting devices (LEDs) comprising:
forming a plurality of light emitting diode (LED) structures on a growth substrate, the light emitting diode (LED) structures including epitaxial structures with sidewalls having sidewall P-N junctions;
forming an isolation layer on the light emitting diode (LED) structures including on the sidewall P-N junctions of the epitaxial structures, the isolation layer including corners at intersections of the epitaxial structures with the growth substrate; and removing the corners of the isolation layer using an etching process leaving the isolation layer covering the sidewall P-N junction.

2. The method of claim 1 wherein the epitaxial structures include undoped layers, n-type layers, active layers and p-type layers, and following the removing of the corners of the isolation layer, the isolation layer covers sidewalls of the p-type layers, sidewalls of the active layers, and portions of sidewalls of the n-type layers.

3. The method of claim 1 wherein the epitaxial structures include mesa surround structures configured to slow down an etching speed/rate during the etching process.

4. The method of claim 1 wherein the growth substrate includes a plurality of streets separating the light emitting diode (LED) structures and following the forming of the isolation layer, the isolation layer covers the streets.

5. The method of claim 1 wherein the growth substrate includes a plurality of streets separating the light emitting diode (LED) structures and following the forming of the isolation layer, the isolation layer only partially covers the streets.

6. The method of claim 1 wherein the etching process includes a first etching process and a second etching process.

7. A method for fabricating semiconductor light emitting devices (LEDs) comprising:
forming a plurality of light emitting diode (LED) structures on a growth substrate, the light emitting diode (LED) structures including epitaxial structures having sidewalls, the epitaxial structures comprising undoped layers, n-type layers, active layers and p-type layers;
forming an isolation layer on the light emitting diode (LED) structures including on the sidewalls of the epitaxial structures, the isolation layer including corners between the undoped layer and the growth substrate;
forming an etchable covering channel layer on the isolation layer;
forming a patterning protection layer on the covering channel layer having a plurality of openings aligned with the corners of the isolation layer;
etching channels in the covering channel layer using a first etching process, in which a first etchant passes through the openings in the patterning protection layer to etch away portions of the covering channel layer;
removing the corners of the isolation layer by etching the isolation layer using a second etching process in which a second etchant passes through the channels to remove the corners, leaving the isolation layer covering sidewalls of the p-type layers, sidewalls of the active layers, and portions of sidewalls of the n-type layers; and
removing the patterning protection layer and the covering channel layer.

8. The method of claim 7 wherein the covering channel layer comprises a metal and the first etching process comprises wet chemical etching of the metal, and wherein the isolation layer comprises an oxide and the second etching process comprises BOE.

9. The method of claim 7 further comprising bonding the growth substrate to a carrier having an elastic polymer material thereon and separating the growth substrate from the light emitting diode (LED) structures using a laser lift off process.

10. The method of claim 7 wherein the growth substrate includes a plurality of streets separating the light emitting diode (LED) structures and following the forming of the isolation layer, the isolation layer covers the streets.

11. The method of claim 7 wherein the growth substrate includes a plurality of streets separating the light emitting diode (LED) structures and following the forming of the isolation layer, the isolation layer only partially covers the streets.

12. A method for fabricating semiconductor light emitting devices (LEDs) comprising:
forming a plurality of light emitting diode (LED) structures on a growth substrate, the light emitting diode (LED) structures including epitaxial structures with sidewalls having sidewall P-N junctions, the light emitting diode (LED) structures separated by street regions on the growth substrate;
forming an isolation layer on the light emitting diode (LED) structures including on the sidewall P-N junctions of the epitaxial structures, the isolation layer covering the street regions and including corners at intersections of the epitaxial structures with the growth substrate;
forming a patterning protection layer on the isolation layer having a plurality of openings aligned with the corners of the isolation layer and the street regions of the growth substrate;
removing portions of the isolation layer in the street regions using a first etching process; and
removing the corners of the isolation layer using a second etching process leaving the isolation layer covering the sidewall P-N junction and forming undercut sidewall structures of the isolation layer on the sidewalls of the epitaxial structures.

13. The method of claim 12 wherein the first etching process comprises a dry etching process and the second etching process comprises a wet etching process.

14. The method of claim 12 wherein the epitaxial structures include undoped layers, n-type layers, active layers and p-type layers, and following the removing of the corners of the isolation layer, the isolation layer covers sidewalls of the p-type layers, sidewalls of the active layers, and portions of sidewalls of the n-type layers.

15. The method of claim 1 or 12 further comprising separating the growth substrate from the light emitting diode (LED) structures using a laser lift off process.

16. The method of claim 7 or 12 wherein the epitaxial structures include mesa surround structures configured to slow down an etching speed/rate during the second etching process.

17. The method of claim 1 or 12 wherein the light emitting diode (LED) structures comprise dual pad (LED) structures or vertical light emitting diode (VLED) structures.

18. A semiconductor light emitting device (LED) comprising:
a light emitting diode (LED) structure including an epitaxial structure having sidewalls, the epitaxial structure comprising an undoped layer, an n-type layer,
active layers, a p-type layer and a sidewall P-N junction; and
an isolation layer covering the sidewall P-N junction, a sidewall of the p-type layer, a sidewall of the active layers, and a portion of a sidewall of the n-type layer.

19. The semiconductor light emitting device (LED) of claim 18 wherein the light emitting diode (LED) structure comprises a dual pad (LED) structure and / or a vertical light emitting diode (VLED) structure.
